# EUROPEAN PATENT SPECIFICATION

(11) **EP 4 100 756 B1**
(45) Date of publication and mention of the grant of the patent: **27.03.2024**
(21) Application number: 20705894.2
(22) Date of filing: 07.02.2020
(51) Int. Cl.: G01R 33/3875, G01R 33/565, G01R 33/567, G01R 33/54

(54) **METHOD TO SHIM A MAGNETIC FIELD AND MAGNETIC RESONANCE MEASUREMENT ARRANGEMENT**
VERFAHREN ZUR EINSTELLUNG EINES MAGNETFELDES UND ANORDNUNG ZUR MESSUNG DER MAGNETRESONANZ
PROCÉDÉ D'HOMOGÉNÉISATION D'UN CHAMP MAGNÉTIQUE ET AGENCEMENT DE MESURE DE RÉSONANCE MAGNÉTIQUE

(43) Date of publication of application: 14.12.2022
(73) Proprietor: MR Shim GmbH, 72760 Reutlingen (DE)
(72) Inventor: NASSIRPOUR, Sahar, 72127 Kusterdingen (DE); CHANG, Yu-Chun, 72070 Tübingen (DE)
(74) Representative: Mertzlufft-Paufler, Cornelius
(86) International application number: PCT/EP2020/053213
(87) International publication number: WO 2021/155956

(56) References cited:
- US-A1- 2008 204 018
- RYAN TOPFER ET AL: "Real-time correction of respiration-induced distortions in the human spinal cord using a 24-channel shim array", MAGNETIC RESONANCE IN MEDICINE., vol. 80, no. 3, 29 January 2018 (2018-01-29), pages 935-946, XP055689590, US ISSN: 0740-3194, DOI: 10.1002/mrm.27089
- MIRIAM R KUBACH ET AL: "NOTE; Cardiac phase-specific shimming (CPSS) for SSFP MR cine imaging at 3 T; Cardiac phase-specific shimming (CPSS)", PHYSICS IN MEDICINE AND BIOLOGY, INSTITUTE OF PHYSICS PUBLISHING, BRISTOL GB, vol. 54, no. 20, 21 October 2009 (2009-10-21), pages N467-N478, XP020163710, ISSN: 0031-9155, DOI: 10.1088/0031-9155/54/20/N01
- VAN GELDEREN P ET AL: "Real-time shimming to compensate for respiration-induced B0 fluctuations", MAGNETIC RESONANCE IN MEDICINE, JOHN WILEY & SONS, INC, US, vol. 57, no. 2, 26 January 2007 (2007-01-26), pages 362-368, XP002442475, ISSN: 0740-3194, DOI: 10.1002/MRM.21136

## Description

The invention relates to a method to shim a magnetic field inside a magnetic resonance apparatus, whereby a subject is placed inside the MR apparatus, whereby a magnetic field heterogeneity distribution of the magnetic field is measured with the MR apparatus, whereby a shim current is determined based on the measured magnetic field heterogeneity distribution, whereby the shim coil is driven with the shim current. The subject may be a human being.

Preferably, the shim current is determined based on the measured magnetic field heterogeneity distribution in a target region-of-interest.

Within the context of this invention, the abbreviation "MR" means "magnetic resonance".

The invention further relates to a magnetic resonance measurement arrangement comprising an MR apparatus and a separate measurement device. The MR apparatus comprises a shim coil. The measurement device that is not the MR apparatus is adapted to measure a physiological characteristic of a subject. It is well known in the art to have such a measurement arrangement. Such an arrangement is for example used to monitor the health status of a patient while an MR measurement of the patient is performed with the MR apparatus. The MR apparatus can for example be an MR imaging apparatus or an MR spectrometer.

A method as described at the beginning is well known in the art. In particular, it is well known that the main magnet of an MR apparatus generates a magnetic field, typically between 0,5 T and 7 T, whereby the magnetic field is not perfectly homogeneous in an imaging volume of the MR apparatus. Inhomogeneities are undesirable as they diminish the quality of the MR signal that may be acquired with the MR apparatus.

Inhomogeneities have several causes. One cause results from the fact that the wire winding of the main magnet does not generate a perfectly constant magnetic field. Another cause results from the anatomy of a subject generating magnetic susceptibility differences that alter the magnetic field. The latter effect is subject-dependent and depends on placement and movement of the subject. The inhomogeneities are usually only in the range of ppm, but they still have a significant impact on signal and image quality.

It is well known in the art to use shim coils to reduce the inhomogeneities and improve the homogeneity of the main magnetic field in order to improve the quality of the measured MR signals.

In order to achieve this, it is known to measure the magnetic heterogeneity distribution of the magnetic field with the MR apparatus. This is also known as the acquisition of a "B0 field map".

It is known to apply a frequency offset and currents to magnetic coils to improve the homogeneity.

To this end, it is known to use the pre-installed shim coils and also the gradients as shim coils and drive them with currents that reduce the heterogeneity of the measured magnetic field heterogeneity distribution. It is also known to use multi-coil shim inserts for shimming.

With a priori knowledge about the magnetic field sensitivity of the shim coils, i.e. the magnetic field that is generated by the shim coils per unit current, and their switching behavior, currents can be calculated that reduce the heterogeneity. Usually, an optimization method is used to determine optimal parameters for the currents.

It is known to perform shimming before acquiring and recording MR data that are used for diagnosis from the patient. Methods are known that perform shimming in real-time, where the currents of the shim coils are updated several times during acquisition of the diagnostic MR data.

It is known to improve the quality of the shim by focusing on a target region-of-interest. The target region-of-interest is usually defined by the acquisition window that is rectangular or cuboid in shape for the usual Cartesian acquisition schemes.

The shimming methods known in the art have lead to a significant increase in image quality. However, in particular for organs that have irregular shapes or alter their shape during an acquisition such as the heart or the liver (which is deformed significantly by breathing), signal and image quality of the acquired MR data is often not satisfactory.

In "Real-time correction of respiration-induced distortions in the human spinal cord using a 24-channel shim array", Magnetic Resonance in Medicine, vol. 80, no. 3, pp. 935-946, Ryan Topfer et al. disclose a system for real-time shimming for a magnetic resonance imaging setup. To track patient respiration in real time, a thin section of vinyl tubing connects the respiratory bellows strapped to the subject's abdomen to a pressure-sensing transducer and microcontroller. The microcontroller feeds pressure measurements into a stand-alone computer, which then issues the associated shim currents to the shim controller.

Miriam R Kubach et al., in "NOTE; Cardiac phase-specific shimming (CPSS) for SSFP MR cine imaging at 3 T; Cardiac phase-specific shimming (CPSS)", Physics in Medicine and Biology, vol. 54, no. 20, pp. N467-N478, report on the assessment of the cardiac phase dependence of the magnetic field distortions over the heart, the potential gain in field homogeneity by CPSS, and significant improvement in the main magnetic field homogeneity over the entire cardiac cycle. In order to determine the shim coefficients, field maps were measured. Then, the outer contours of the heart are manually drawn in each slice for each cardiac phase. The derived 3D contour are then applied as a region of interest. Subsequently, the shim coefficients are determined by means of a least-squares fit.

In "Real-time shimming to compensate for respiration-induced B0 fluctuations", Magnetic Resonance in Medicine, vol. 57, no. 2, pp. 362-368, van Gelderen et al. report on the compensation of field fluctuations by modulating the B0 shims in real time, based on a reference scan acquired to measure the spatial distribution of the B0 effect related to chest motion.

US 2008/204018 A1 discloses a method for determination or adaptation of a shim for homogenisation of a magnetic field of a magnetic resonance apparatus, an automatic determination, of a computer and/or supported by an operator on an image output unit of the computer, is made of a three-dimensional volume that is relevant for the determination or adaptation of the shim and that is matched to the examination region and/or an examination protocol by selection from an arbitrary morphology set of selectable volumes and/or by generation of an arbitrarily three-dimensional volume not limited to specific shapes. The computer then automatically calculates the shim for the determined or selected three-dimensional volume.

In view of the above, it is an object of the invention to improve the quality of the shim for an MR apparatus.

To achieve this object, the invention proposes the technical features according to claim 1. In particular, according to the invention it is provided that for a method to shim a magnetic field of the type described at the beginning that a physiological characteristic of the subject is measured and used to determine the shim current.

The physiological characteristic is preferably measured with a separate measurement device that is not the MR apparatus. Some embodiments of such a measurement device are described below.

A physiological characteristic may be given by an internal state or a process of the body of the subject.

Opposed to a physiological characteristic is an anatomical characteristic that refers to mere structural information of the body. Therefore, for example blood pressure, heart rate, current state within a respiratory cycle may be considered as a physiological characteristic. While the geometrical shape of an organ may not be considered a physiological characteristic, the current state of the organ within a cyclic internal movement of the organ may be considered a physiological characteristic. For example, diastole and systole may be considered a physiological characteristic.

Also, the influence of the subject on its environment is not considered as a physiological characteristic. For example, the introduction of magnetic field inhomogeneities generated by a human body placed in a magnetic field does not refer to a physiological characteristic.

Measuring a physiological characteristic and using this information to determine the shim current can be beneficial as it may be easy to measure the physiological characteristic. Such a characteristic may bear information about the current state of a functional unit of the subject. Therefore, also structural information of the functional unit and information of its influence on the heterogeneity of the magnetic field may be retrieved from the measured physiological characteristic. For example, measurement of the pulse may give information about the current state of the heart within the heart cycle. This information also bears information about the state of contraction of the heart and therefore information about the shape and size of the heart may be deduced from this. This information can then be used in a versatile way to improve the shim. Some embodiments are explained below. According to the invention, a shim current is determined based on the measured magnetic field heterogeneity distribution. This shall mean that at least one shim current is determined. The invention therefore covers determination of a single current, but also of several currents. The shim coil may therefore be an isolated coil. However, usage of more than one shim coil will often lead to a better shimming. Particularly good shimming results can be achieved by using a local multi-coil shim insert. Such an insert can be placed near the imaging region and therefore has good capabilities of altering and homogenizing the magnetic field. In such a case it will be beneficial to determine shim currents for each shim coil that constitute the shim insert.

The physiological characteristic may be a cyclic physiological characteristic. In particular, it may be a cardiac signal and/or a respiratory signal. Measuring a recurring characteristic can be beneficial because such a characteristic can be measured and processed easily.

According to an advantageous embodiment of the invention the physiological characteristic is measured continuously. Monitoring the physiological characteristic has the advantage that data is readily available for further processing in the shim routine, which allows for flexible real-time imaging.

According to the invention the physiological characteristic is measured while data is acquired with the MR apparatus, wherein the data is diagnostic data. The parallel acquisition of MR data and the physiological characteristic has the advantage that MR data acquisition can be accelerated, which leads to reduced costs for an MR scan. No additional time slots in between MR data acquisition need to be reserved for acquiring additional field maps that are usually necessary for real-time shimming.

The shim current may be determined by generating a digital model of the magnetic field heterogeneity distribution in the target region-of-interest and by automatically calculating parameters that reduce the magnetic field heterogeneity inside the target region-of-interest and by assigning one of the parameters to the shim current. Preferably, a spatial field distribution and/or temporal switching characteristics of the shim coil are determined and used in the calculation of the parameters. Further, the parameters are preferably calculated by way of an optimization method.

According to the invention the measured physiological characteristic is used to determine the target region-of-interest. The additional information provided by the measured physiological characteristic can be used to find a more suitable region-of-interest, which can lead to an improvement of the quality of the shim.

It can be advantageous to determine for at least one reference value of the physiological characteristic at least one reference region-of-interest. This is preferably done by an MR measurement. An MR measurement may be characterized by the acquisition of MR data using the MR apparatus. It can also be advantageous to determine the target region-of-interest based on a or the at least one reference region-of-interest. This is preferably done by applying an estimation method. In case the physiological characteristic is cyclic, it can be beneficial when the first reference value is given by a first position in a cycle of the physiological characteristic. Such embodiments have the advantage that the additional information provided by the at least one reference region-of-interest can lead to a more focused target region-of-interest.

The target region-of-interest may be determined by an extrapolation method. The target region-of-interest may also be determined by interpolating between at least two reference regions-of-interest. The reference regions-of-interest are preferably taken from the at least one reference regions-of-interests that have already been mentioned before. Such methods lead to a high-quality estimation of the desired target region-of-interest.

The target region-of-interest and/or the at least one reference region-of-interest may be defined by a geometrical shape of a functional unit inside the body of the subject. A functional unit may for example be given by an organ. Preferably, an image segmentation method is used to define the geometrical shape of the functional unit. The region-of-interest could be given by the geometrical shape of the functional unit, however, there might also be some deviations, e.g. the boundaries may be smoothened or a distance might be allowed between the boundaries of the shape of the functional unit and the boundaries of the target region-of-interest. Using the shape of a functional unit to define the target region-of-interest can be beneficial in case diagnostic information shall be acquired from this functional unit. In this case, the shim can be focused to the part of the subject that is of interest to the user of the MR apparatus.

Data of the subject, in particular of the functional unit of the subject, acquired with the MR apparatus may be used to determine the at least one reference region-of-interest. Alternatively or additionally, the measured physiological characteristic and/or a priori knowledge about the temporal evolution of the physiological characteristic may be used to determine the at least one reference region-of-interest and/or the target region-of-interest. Also, a priori knowledge about the spatio-temporal evolution of the functional unit may be used to determine the at least one reference region-of-interest and/or the target region-of-interest. A priori information may be taken from previous measurements of the same subject or from other subjects, simulation results, model data or from other sources of information. Such embodiments have the advantage that a better estimate for an optimal target region-of-interest may be found.

According to a further embodiment of the invention the magnetic field heterogeneity distribution is measured at at least one point in time, the physiological characteristic is measured at a second point in time and the magnetic field heterogeneity distribution at the second point in time is determined based on the measured magnetic field heterogeneity distribution at the at least one point in time. For this purpose, preferably, an estimation method is applied. The additional information provided by the measured physiological characteristic can be used to find a high-quality estimate of the real magnetic field heterogeneity at the second point in time. With some prior knowledge about the temporal evolution of the physiological characteristic, the physiological characteristic may alternatively be estimated at the second point in time. Preferably, to find a good estimate, the estimation of the physiological characteristic makes use of a measurement of the physiological characteristic at a third point in time.

A priori knowledge about the spatio-temporal evolution of the magnetic field heterogeneity distribution may be used to determine the magnetic field heterogeneity distribution at the second point in time. Preferably, a priori knowledge about the spatio-temporal evolution of the magnetic field heterogeneity distribution is deduced from a priori knowledge about the spatio-temporal evolution of the functional unit and/or from a priori knowledge about the temporal evolution of the measured physiological characteristic. Such embodiments can lead to high-quality estimations of the real magnetic field heterogeneity distribution at the second point in time.

The magnetic field heterogeneity distribution at the second point in time may be determined by an extrapolation method and/or by interpolating between two measured magnetic field heterogeneity distributions. Such methods lead to a high-quality estimation of the desired target region-of-interest.

The shim current may be determined during an acquisition of MR data. Preferably, the shim current is determined several times during the acquisition of MR data. In particular, the shim current is determined in real-time. Preferably, the shim current determination or updates occur during an acquisition of diagnostic MR data.

Diagnostic MR data may be data acquired with a diagnostic MR acquisition scheme and processed for further diagnostic evaluation.

To achieve the above-mentioned object of the invention, the invention proposes the technical features according to claim 14. In particular, according to the invention it is provided that for an MR arrangement of the type described at the beginning that the measurement device is connected to the MR apparatus and that the MR measurement arrangement is configured to perform the method that is formed according to this invention, i.e. that has the technical features of the inventive method as described here and/or that has the technical features of the patent claims that protect the inventive method. Such an MR arrangement shares the advantages that have already been described above with respect to corresponding embodiments of the inventive method.

Preferably, the shim coil is part of a multi-coil shim insert.

The measurement device may be a device that is configured to measure a physiological characteristic. Preferably, the device is a device to measure a cardiac signal of a subject. The device may for example be a finger tip cardiac trigger that may be clipped to the finger of the subject and that is configured to measure a pulse of the subject. In another preferred embodiment, the device is a device to measure a respiratory signal of a subject. Such a device may for example be a respiratory belt. The belt may be adapted to be girt around the body, preferably the torso, of the subject. Such devices can be useful to collect the physiological data of the subject that can then be used to improve the shimming method in a way as described above.

The invention will now be described in more detail on the basis of a small number of specific embodiments, but is not restricted to these few specific embodiments. Further embodiments are provided by combining the features of one or more of the claims with one another and/or with one or more features of the variants of the inventive method and the inventive MR arrangement that have been described before and that will be described below.

In the figures
- Fig. 1: shows an embodiment of an MR arrangement according to the invention;
- Fig. 2: illustrates important features of an embodiment of a method according to the invention.

In the following, the same reference signs may be used for elements which correspond to each other in terms of their function even though their configuration or shape might differ.

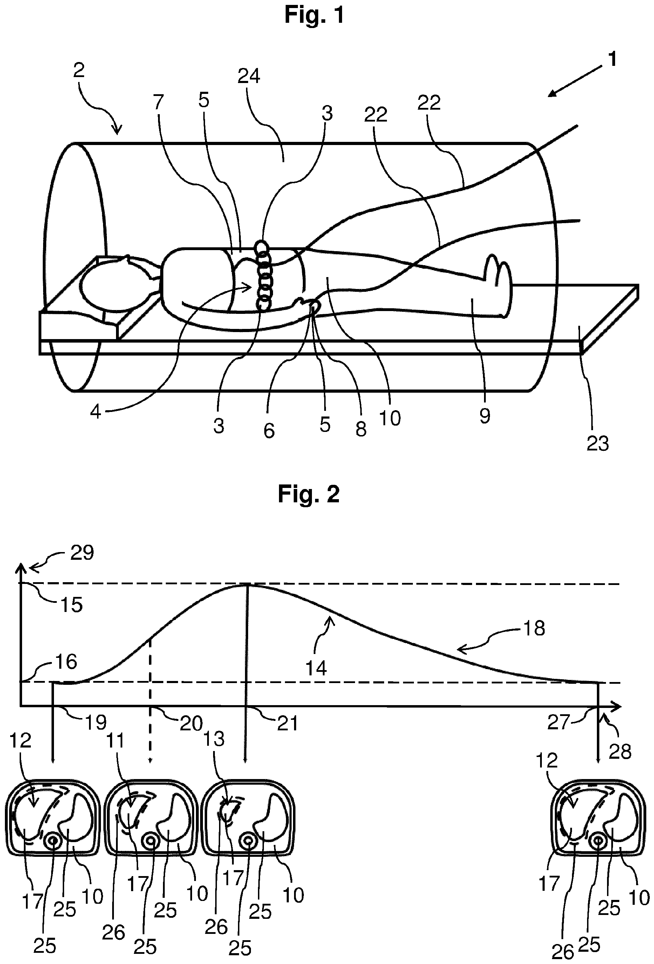

The MR arrangement 1 shown in Fig. 1 comprises an MR apparatus 2 that forms an MR imaging scanner. From the MR imaging scanner only the inner wall 24 of the cylindrically-shaped bore is shown.

The MR apparatus 2 has the usual components. Among them is a superconducting main magnet which generates a magnetic field that is essentially constant in the imaging region. This magnetic field typically has a field strength between 0,5 Tesla and 7 Tesla and is usually used to orient the spins of the hydrogen nuclei of the measurement object such as the human subject 9 that may lie on the patient table 23. The MR apparatus 2 also has a radiofrequency (rf) transmit coil for flipping the spins such that they emit an MR signal that may then be acquired with an rf receive coil. The MR apparatus 2 is further equipped with a gradient system that has the usual x-, y- and z-gradients which may be used among others for signal localization that allows reconstruction of an MR image. For the reconstruction, the acquisition channel is connected to a computer where image reconstruction may be performed. The MR apparatus 2 also has a pre-installed shim system as it is well known in the art.

Apart from the pre-installed shim system the MR apparatus 2 is further equipped with a multi-coil shim insert 4 that comprises a multitude of individual shim coils 3 that might each be driven with a different shim current. For an MR measurement, the shim insert 4 is brought in close proximity to the body 10 of the subject 9 near the functional unit 17 for which diagnostic information is supposed to be acquired with the MR apparatus 2. The body 10 has a multitude of different functional units 17, 25.

Apart from the MR apparatus 2, the MR arrangement 1 further comprises two measurement devices 5 that are each capable of measuring a physiological property of a human subject. One measurement device 5 comprises a finger tip cardiac trigger 6. This device 5 is clipped on a finger 8 of the subject 9 and is capable of tracking the cardiac cycle by providing a voltage signal that changes during the cardiac cycle. Another measurement device 5 comprises a respiratory belt 7 that may be girt around the body 10, in Fig. 1 around the torso of the subject 9. Both measurement devices 5, 6, 7 are connected to a controller and/or a computer (which is not explicitly shown in Fig. 1) via cables 22.

The MR arrangement 1 may be used to perform a method according to this invention. A specific embodiment of such a shimming method is described here. Some important features of this embodiment are illustrated in Fig. 2.

Before the shimming procedure is actually being executed a subject 9 is prepared for measurement.

In case of cardiac imaging, a suitable measurement device 5 such as the fingertip cardiac trigger 6 as described above is installed. In Fig. 2, it is the aim of acquiring diagnostic MR data from the liver of the subject 9. The liver 9 is an organ and functional unit 17 of the body 10 whose size and shape changes significantly during within the respiratory cycle.

This property is illustrated in Fig. 2. At a first time point 19, the functional unit 17, which is the liver, has its largest extension. At a second time point 20 the functional unit 17 is smaller and at a third time point 21 the functional unit 17 has its smallest extension. At the fourth time point 27 the respiratory cycle restarts. Therefore, the fourth time point 27 and the first time point 19 are at the same location in the respiratory cycle. The two time points 19, 27 are therefore corresponding time points 19, 27 in a cycle of the physiological characteristic 14.

In order to capture the current location within the respiratory cycle, which is a physiological characteristic 14, a respiratory belt 7 is placed around the torso of the subject 9 and connected via a cable 22 to a processing unit that can process the signal that is generated by the respiratory belt 7. The measurement device 5 tracks the temporal evolution 18 of the physiological characteristic 14. To this end, the respiratory belt 7 generates a voltage signal, whereby the voltage level changes from low to high when the subject 9 moves from inhalation to exhalation.

This is illustrated in Fig. 2. In Fig. 2, a graph is shown where the x-axis 28 represents time and the y-axis 29 represents the voltage level that is generated by the measurement device 5. At or near time point 19 the voltage has its lowest level and at or near time point 21 the voltage has its highest level.

Then, the local multi-coil shim insert 4 is brought into position in near proximity of the functional unit 17.

After preparation of the measurement devices 5, the patient table 23 with the subject 9 lying on it is being moved into the bore of the MR apparatus 2 and places the functional unit 17 near the center of the optimal imaging region of the MR apparatus 2.

After those preparatory measures the subject 9 is prepared and ready to be imaged.

Before the acquisition of diagnostic MR data is started, execution of the shimming procedure is started.

To this end, a priori knowledge is used that the voltage level of the measurement device 5 is correlated to the shape and size of the functional unit 17. A first reference value 15 and a second reference value 16 are defined. The first reference value 15 might be defined as the lowest of the measured voltage level. The second reference value 16 might be defined to be the highest voltage level. The highest level occurs at time point 21 when the functional unit 17 has its smallest extension. The lowest level occurs at or near time point 19, when the functional unit 17 has its largest extension. The correlation of size of functional unit 17 and voltage level might often not be as simple in practice.

At those two time points 19, 21 or corresponding time points in the respiratory cycle such as at time point 27, the magnetic field heterogeneity distribution is measured with the MR apparatus 2. Any known method can be used for those measurements.

Once those two field maps have been acquired, the magnetic field heterogeneity distribution at any other time point such as at time point 20 can be estimated without the need to acquire another field map. Methods have already been described above that may be used to estimate the magnetic field heterogeneity distribution based on knowledge of the two reference magnetic field heterogeneity distributions. For example the magnetic field heterogeneity distribution at time point 20 may be estimated using an interpolation method. The closer the time point 20 gets to time point 19 resp. 21 the closer the heterogeneity distribution will be to the distribution at time point 19 resp. 21.

Time point 20 may be defined by a shim updating scheme that follows a predefined rule. A simple rule might be to perform a shim update in regular time intervals. Therefore, at regular time points such as at time point 20, an estimation of the magnetic field heterogeneity distribution will be required.

Optimal shim currents may then be calculated automatically as has already been described above. To do this, it is necessary to define a target region-of-interest 11.

The target region-of-interest 11 might be defined to be a cuboid box that surrounds the functional unit 17. However, the target region-of-interest 11 might also be adapted more closely to the shape of the functional unit 17. This might be achieved for example by acquiring anatomical information about the functional unit 17 at time points 19 and 21. The functional unit 17 might then be segmented using any known segmentation method. By way of this method, it is possible to determine boundaries 26 of the segmented objects. Those boundaries 26 represent the shape of the functional unit 17. A first and second reference region-of-interests 12, 13 may then be set to be the regions that are covered by the boundaries 26 that have been determined as described before. In Fig. 2, a boundary 26 is depicted as a dashed line, the shape of the functional unit 17 is depicted as a solid line.

With this information, the shape and size of the functional unit 17 may be estimated at any other time point such as at time point 20. Methods to perform such an estimate have already been described above. For example, an interpolation method might be used where the resulting shape at time point 20 is a shape that is in between the shape of the functional unit 17 at time point 19 and at time point 21. The closer the time point 20 gets to time point 19 resp. 21 the closer the interpolated shape of the functional unit 17 will come to its shape at time point 19 resp. 21.

The target region-of-interest 11 can then be set to be the region that is covered by the boundaries 26 of the estimated shape of the functional unit 17.

Optimization of shim currents for time point 20 can then be performed within the target region-of-interest 11. For example, a digital model of the estimated magnetic field heterogeneity distribution might be generated in the target region-of-interest 11 by assigning locations in the target region-of-interest 11 corresponding values of the estimated magnetic field heterogeneity distribution. Then, parameters are calculated that best reduce the magnetic field heterogeneity distribution within the target region-of-interest 11 by way of any known optimization method. To this end, a priori knowledge about the magnetic field sensitivity of the shim coils 3 and their switching behavior may be used. This information might be found in advance by any method known to the person skilled in the art, for example by using measurement or simulation data of the magnetic fields that are generated by the individual shim coils 3 of the shim insert 4.

The method also works for standard pre-installed shim systems.

Once the optimal shim currents are determined the shim currents are applied to the individual shim coils 3.

This procedure may be performed only once, but preferably several times for optimal shimming in real-time.

After an initial shim, diagnostic MR data of the functional unit 17 can be acquired in parallel and essentially independently of the shim procedure.

In summary, a novel method to shim a magnetic field inside an MR apparatus 2 is described as well as an advantageous MR arrangement 1 that may be used to perform the novel method. For the shimming, that can also be done in real-time, a physiological characteristic 14 of the subject 9 is measured and used to determine optimal shim currents. The method works with standard pre-installed shim systems, but is particularly beneficial for local multi-coil shim inserts 4.

### List of reference signs

- 1: MR measurement arrangement
- 2: MR apparatus
- 3: shim coil
- 4: multi-coil shim insert
- 5: measurement device
- 6: finger tip cardiac trigger
- 7: respiratory belt
- 8: finger
- 9: subject
- 10: body
- 11: target region-of-interest
- 12: a first reference region-of-interest
- 13: a second reference region-of-interest
- 14: physiological characteristic
- 15: a first reference value of 14
- 16: a second reference value of 14
- 17: functional unit
- 18: temporal evolution of 14
- 19: a first point in time
- 20: a second point in time
- 21: a third point in time
- 22: cable
- 23: patient table
- 24: bore wall
- 25: another functional unit
- 26: boundary
- 27: a fourth point in time
- 28: x-axis
- 29: y-axis

## Claims

1. Method to shim a magnetic field inside an MR apparatus (2), whereby a subject (9) is placed inside the MR apparatus (2), whereby a magnetic field heterogeneity distribution of the magnetic field is measured with the MR apparatus (2), whereby a shim current is determined based on the measured magnetic field heterogeneity distribution in a target region-of-interest (11), whereby the shim coil (3, 4) is driven with the shim current, whereby a physiological characteristic (14) of the subject (9) is measured and used to determine the shim current and whereby the physiological characteristic (14) is measured and the shim current is determined and updated while diagnostic data is acquired with the MR apparatus (2) **characterized in that** the measured physiological characteristic (14) is used to determine the target region-of-interest (11).

2. Method according to the previous claim **characterized in that** the physiological characteristic (14) is a cyclic physiological characteristic (14), in particular a cardiac signal and/or a respiratory signal (14).

3. Method according to any of the previous claims **characterized in that** the physiological characteristic (14) is measured continuously.

4. Method according to any of the previous claims **characterized in that** the shim current is determined by generating a digital model of the magnetic field heterogeneity distribution in the target region-of-interest (11) and by automatically calculating parameters that reduce the magnetic field heterogeneity inside the target region-of-interest (11), preferably using an optimization method, and by assigning one of the parameters to the shim current, in particular whereby a spatial field distribution and/or temporal switching characteristics of the shim coil (3, 4) are determined and used in the calculation of the parameters.

5. Method according to any of the previous claims **characterized in that** for at least one reference value (15, 16) of the physiological characteristic (14) at least one reference region-of-interest (12, 13) is determined, in particular by an MR measurement, and that the target region-of-interest (11) is determined based on the at least one reference region-of-interest (12, 13), in particular by applying an estimation method.

6. Method according to any of the previous claims **characterized in that** the target region-of-interest (11) is determined by an extrapolation method and/or that the target region-of-interest (11) is determined by interpolating between at least two reference regions-of-interest (12, 13).

7. Method according to any of the previous claims **characterized in that** the target region-of-interest (11) and/or the at least one reference region-of-interest (12, 13) are defined by a geometrical shape of a functional unit (17) inside the body (10) of the subject (9), such as an organ (17), in particular whereby an image segmentation method is used to define the geometrical shape of the functional unit (17).

8. Method according to any of the previous claims **characterized in that** data of the subject (9), in particular of the functional unit (17) of the subject (9), acquired with the MR apparatus (2) is used to determine the at least one reference region-of-interest (12, 13) and/or that the measured physiological characteristic (14) and/or a priori knowledge about the temporal evolution (18) of the physiological characteristic (14) and/or the functional unit (17) is used to determine the at least one reference region-of-interest (12, 13) and/or the target region-of-interest (11).

9. Method according to any of the previous claims **characterized in that** the magnetic field heterogeneity distribution is measured at at least one point in time (19, 20, 21, 27), that the physiological characteristic (14) is measured or estimated at a second point in time (19, 20, 21, 27) and that the magnetic field heterogeneity distribution at the second point in time (19, 20, 21, 27) is determined based on the measured magnetic field heterogeneity distribution at the at least one point in time (19, 20, 21, 27), in particular by applying an estimation method.

10. Method according to the previous claim **characterized in that** a priori knowledge about the spatio-temporal evolution of the magnetic field heterogeneity distribution is used to determine the magnetic field heterogeneity distribution at the second point in time (19, 20, 21, 27), in particular whereby the a priori knowledge about the spatio-temporal evolution of the magnetic field heterogeneity distribution is deduced from a priori knowledge about the spatio-temporal evolution of the functional unit (17) and/or from a priori knowledge about the temporal evolution (18) of the measured physiological characteristic (14).

11. Method according to any of the two previous claims **characterized in that** the magnetic field heterogeneity distribution at the second point in time (19, 20, 21, 27) is determined by an extrapolation method and/or by interpolating between two measured magnetic field heterogeneity distributions.

12. Method according to any of the previous claims **characterized in that** the shim current is determined during an acquisition of MR data, in particular whereby the shim current is determined several times during the acquisition of MR data or whereby the shim current is determined in real-time.

13. MR measurement arrangement (1) comprising an MR apparatus (2) having a shim coil (3, 4) and comprising a separate measurement device (5, 6, 7) to measure a physiological characteristic (14) of a subject (9), **characterized in that** the measurement device (5, 6, 7) is connected to the MR apparatus (2) and that the MR measurement arrangement (1) is configured to perform the method of any of the previous claims.

14. MR measurement arrangement (1) according to the previous claim, **characterized in that** the shim coil (3, 4) is part of a multi-coil shim insert (4).

15. MR measurement arrangement (1) according to any of the two previous claims **characterized in that** the device (5, 6, 7) is a device (6) that is adapted to measure a cardiac signal (14) of the subject, such as a pulse of the subject, in particular whereby the device (5, 6, 7) is a finger tip cardiac trigger (6) that may be clipped to the finger (8) of the subject (9), and/or that the device (5, 6, 7) is a device (7) to measure a respiratory signal (14) of a subject (9) such as a respiratory belt (7) that may preferably be girt around the body (10), in particular around the torso (10), of the subject (9).

## Patentansprüche

1. Verfahren zum Shimmen eines Magnetfeldes innerhalb eines MR-Geräts (2), wobei ein Subjekt (9) innerhalb des MR-Geräts (2) platziert wird, wobei eine Verteilung der Magnetfeldheterogenität des Magnetfeldes mit dem MR-Gerät (2) gemessen wird, wobei ein Shimstrom basierend auf der gemessenen Verteilung der Magnetfeldheterogenität in einer Zielinteressensregion (11) bestimmt wird, wobei die Shimspule (3, 4) mit dem Shimstrom angetrieben wird, wobei ein physiologisches Charakteristikum (14) des Subjekts (9) gemessen und verwendet wird, um den Shimstrom zu bestimmen, und wobei das physiologische Charakteristikum (14) gemessen wird und der Shimstrom bestimmt und aktualisiert wird, während diagnostische Daten mit dem MR-Gerät (2) erfasst werden, **dadurch gekennzeichnet, dass** das gemessene physiologische Charakteristikum (14) verwendet wird, um die Zielinteressensregion (11) zu bestimmen.

2. Verfahren nach dem vorhergehenden Anspruch, **dadurch gekennzeichnet, dass** das physiologische Charakteristikum (14) ein zyklisches physiologisches Charakteristikum (14) ist, insbesondere ein Herzsignal und/oder ein Atemsignal (14).

3. Verfahren nach einem der vorhergehenden Ansprüche, **dadurch gekennzeichnet, dass** das physiologische Charakteristikum (14) kontinuierlich gemessen wird.

4. Verfahren nach einem der vorhergehenden Ansprüche, **dadurch gekennzeichnet, dass** der Shimstrom bestimmt wird durch Generieren eines digitalen Modells der Verteilung der Magnetfeldheterogenität in der Zielinteressensregion (11) und durch automatisches Berechnen von Parametern, die die Magnetfeldheterogenität innerhalb der Zielinteressensregion (11) reduzieren, vorzugsweise unter Verwendung eines Optimierungsverfahrens, und durch Zuweisen von einem der Parameter zu dem Shimstrom, wobei insbesondere eine räumliche Feldverteilung und/oder zeitliche Schaltcharakteristika der Shimspule (3, 4) bestimmt und in der Berechnung der Parameter verwendet wird/werden.

5. Verfahren nach einem der vorhergehenden Ansprüche, **dadurch gekennzeichnet, dass** für mindestens einen Referenzwert (15, 16) des physiologischen Charakteristikums (14) mindestens eine Referenzinteressensregion (12 13) bestimmt wird, insbesondere durch eine MR-Messung, und dass die Zielinteressensregion (11) basierend auf der mindestens einen Referenzinteressensregion (12, 13) bestimmt wird, insbesondere durch Anwendung eines Schätzungsverfahrens.

6. Verfahren nach einem der vorhergehenden Ansprüche, **dadurch gekennzeichnet, dass** die Zielinteressensregion (11) mittels eines Extrapolationsverfahrens bestimmt wird, und/oder dass die Zielinteressensregion (11) mittels Interpolieren zwischen mindestens zwei Referenzinteressensregionen (12, 13) bestimmt wird.

7. Verfahren nach einem der vorhergehenden Ansprüche, **dadurch gekennzeichnet, dass** die Zielinteressensregion (11) und/oder die mindestens eine Referenzinteressensregion (12, 13) durch eine geometrische Form einer funktionellen Einheit (17) innerhalb des Körpers (10) des Subjekts (9), wie eines Organs (17), definiert wird/werden, wobei insbesondere ein Bildsegmentierungsverfahren verwendet wird, um die geometrische Form der funktionellen Einheit (17) zu definieren.

8. Verfahren nach einem der vorhergehenden Ansprüche, **dadurch gekennzeichnet, dass** Daten des Subjekts (9), insbesondere von der funktionellen Einheit (17) des Subjekts (9), die mit dem MR-Gerät (2) erfasst wurden, verwendet werden, um die mindestens eine Referenzinteressensregion (12, 13) zu bestimmen, und/oder dass das gemessene physiologische Charakteristikum (14) und/oder eine a-priori-Kenntnis der zeitlichen Entwicklung (18) des physiologischen Charakteristikums (14) und/oder der funktionellen Einheit (17) verwendet wird/werden, um die mindestens eine Referenzinteressensregion (12, 13) und/oder die Zielinteressensregion (11) zu bestimmen.

9. Verfahren nach einem der vorhergehenden Ansprüche, **dadurch gekennzeichnet, dass** die Verteilung der Magnetfeldheterogenität an mindestens einem Zeitpunkt (19, 20, 21, 27) gemessen wird, dass das physiologische Charakteristikum (14) an einem zweiten Zeitpunkt (19, 20, 21, 27) gemessen oder geschätzt wird, und dass eine Verteilung der Magnetfeldheterogenität an dem zweiten Zeitpunkt (19, 20, 21, 27) basierend auf der gemessene Verteilung der Magnetfeldheterogenität an dem mindestens einen Zeitpunkt (19, 20, 21, 27) bestimmt wird, insbesondere durch Anwenden eines Schätzverfahrens.

10. Verfahren nach dem vorhergehenden Anspruch, **dadurch gekennzeichnet, dass** a-priori-Kenntnis zu der räumlich-zeitlichen Entwicklung der Verteilung der Magnetfeldheterogenität verwendet wird, um die Verteilung der Magnetfeldheterogenität an dem zweiten Zeitpunkt (19, 20, 21, 27) zu bestimmen, wobei insbesondere die a-priori-Kenntnis zu der räumlich-zeitlichen Entwicklung der Verteilung der Magnetfeldheterogenität aus einer a-priori-Kenntnis der räumlich-zeitlichen Entwicklung der funktionellen Einheit (17) und/oder aus einer a-priori-Kenntnis der zeitlichen Entwicklung (18) des gemessenen physiologischen Charakteristikums (14) gefolgert wird.

11. Verfahren nach einem der zwei vorhergehenden Ansprüche, **dadurch gekennzeichnet, dass** die Verteilung der Magnetfeldheterogenität an dem zweiten Zeitpunkt (19, 20, 21, 27) mittels eines Extrapolationsverfahrens und/oder mittels Interpolieren zwischen zwei gemessenen Verteilungen der Magnetfeldheterogenität bestimmt wird.

12. Verfahren nach einem der vorhergehenden Ansprüche, **dadurch gekennzeichnet, dass** der Shimstrom während einer Erfassung von MR-Daten bestimmt wird, wobei insbesondere der Shimstrom mehrfach während der Erfassung von MR-Daten bestimmt wird, oder wobei der Shimstrom in Echtzeit bestimmt wird.

13. MR-Messanordnung (1), umfassend ein MR-Gerät (2) mit einer Shimspule (3, 4), und umfassend eine separate Messvorrichtung (5, 6, 7) zum Messen eines physiologischen Charakteristikums (14) eines Subjekts (9), **dadurch gekennzeichnet, dass** die Messvorrichtung (5, 6, 7) mit dem MR-Gerät (2) verbunden ist, und dass die MR-Messanordnung (1) ausgestaltet ist, um das Verfahren gemäß einem der vorhergehenden Ansprüche durchzuführen.

14. MR-Messanordnung (1) nach dem vorhergehenden Anspruch, **dadurch gekennzeichnet, dass** die Shimspule (3, 4) Teil eines Shimeinsatzes mit mehreren Spulen (4) ist.

15. MR-Messanordnung (1) nach einem der zwei vorhergehenden Ansprüche, **dadurch gekennzeichnet, dass** die Vorrichtung (5, 6, 7) eine Vorrichtung (6) ist, die eingerichtet ist, um ein Herzsignal (14) des Subjekts, wie einen Puls des Subjekts, zu messen, wobei insbesondere die Vorrichtung (5, 6, 7) ein Fingerspitzen-Pulsmesser (6) ist, der auf den Finger (8) des Subjekts (9) geklemmt werden kann, und/oder dass die Vorrichtung (5, 6, 7) eine Vorrichtung (7) zum Messen eines Atemsignals (14) des Subjekts (9) ist, wie ein Atemgürtel (7), der vorzugsweise um den Körper (10) gegurtet werden kann, insbesondere um den Torso (10) des Subjekts (9).

## Revendications

1. Procédé d'homogénéisation d'un champ magnétique à l'intérieur d'un appareil de RM (2), dans lequel un sujet (9) est placé à l'intérieur de l'appareil de RM (2), dans lequel une distribution d'hétérogénéité de champ magnétique du champ magnétique est mesurée avec l'appareil de RM (2), dans lequel un courant d'homogénéisation est déterminé sur la base de la distribution d'hétérogénéité de champ magnétique mesurée dans une région d'intérêt cible (11), dans lequel la bobine d'homogénéisation (3, 4) est entraînée avec le courant d'homogénéisation, dans lequel une caractéristique physiologique (14) du sujet (9) est mesurée et utilisée pour déterminer le courant d'homogénéisation et dans lequel la caractéristique physiologique (14) est mesurée et le courant d'homogénéisation est déterminé et mis à jour pendant que des données de diagnostic sont acquises avec l'appareil de RM (2), **caractérisé en ce que** la caractéristique physiologique mesurée (14) est utilisée pour déterminer la région d'intérêt cible (11).

2. Procédé selon la revendication précédente, **caractérisé en ce que** la caractéristique physiologique (14) est une caractéristique physiologique cyclique (14), en particulier un signal cardiaque et/ou un signal respiratoire (14).

3. Procédé selon l'une quelconque des revendications précédentes, **caractérisé en ce que** la caractéristique physiologique (14) est mesurée en continu.

4. Procédé selon l'une quelconque des revendications précédentes, **caractérisé en ce que** le courant d'homogénéisation est déterminé en générant un modèle numérique de la distribution d'hétérogénéité de champ magnétique dans la région d'intérêt cible (11) et en calculant automatiquement des paramètres qui réduisent l'hétérogénéité de champ magnétique à l'intérieur de la région d'intérêt cible (11), de préférence en utilisant un procédé d'optimisation, et en attribuant un des paramètres au courant d'homogénéisation, en particulier dans lequel une distribution de champ spatiale et/ou des caractéristiques de commutation temporelle de la bobine d'homogénéisation (3, 4) sont déterminées et utilisées dans le calcul des paramètres.

5. Procédé selon l'une quelconque des revendications précédentes, **caractérisé en ce que** pour au moins une valeur de référence (15, 16) de la caractéristique physiologique (14), au moins une région d'intérêt de référence (12, 13) est déterminée, en particulier par une mesure de RM, et **en ce que** la région d'intérêt cible (11) est déterminée sur la base de la au moins une région d'intérêt de référence (12, 13), en particulier en appliquant un procédé d'estimation.

6. Procédé selon l'une quelconque des revendications précédentes, **caractérisé en ce que** la région d'intérêt cible (11) est déterminée par un procédé d'extrapolation et/ou **en ce que** la région d'intérêt cible (11) est déterminée par interpolation entre au moins deux régions d'intérêt de référence (12, 13).

7. Procédé selon l'une quelconque des revendications précédentes, **caractérisé en ce que** la région d'intérêt cible (11) et/ou la au moins une région d'intérêt de référence (12, 13) sont définies par une forme géométrique d'une unité fonctionnelle (17) à l'intérieur du corps (10) du sujet (9), comme un organe (17), en particulier dans lequel un procédé de segmentation d'image est utilisé pour définir la forme géométrique de l'unité fonctionnelle (17).

8. Procédé selon l'une quelconque des revendications précédentes, **caractérisé en ce que** des données du sujet (9), en particulier de l'unité fonctionnelle (17) du sujet (9), acquises avec l'appareil de RM (2) sont utilisées pour déterminer la au moins une région d'intérêt de référence (12, 13) et/ou **en ce que** la caractéristique physiologique mesurée (14) et/ou une connaissance a priori de l'évolution temporelle (18) de la caractéristique physiologique (14) et/ou de l'unité fonctionnelle (17) sont utilisées pour déterminer la au moins une région d'intérêt de référence (12, 13) et/ou la région d'intérêt cible (11).

9. Procédé selon l'une quelconque des revendications précédentes, **caractérisé en ce que** la distribution d'hétérogénéité de champ magnétique est mesurée au niveau d'au moins un point dans le temps (19, 20, 21, 27), **en ce que** la caractéristique physiologique (14) est mesurée ou estimée au niveau d'un second point dans le temps (19, 20, 21, 27) et **en ce que** la distribution d'hétérogénéité de champ magnétique au niveau du second point dans le temps (19, 20, 21, 27) est déterminée sur la base de la distribution d'hétérogénéité de champ magnétique mesurée au niveau du au moins un point dans le temps (19, 20, 21, 27), en particulier en appliquant un procédé d'estimation.

10. Procédé selon la revendication précédente, **caractérisé en ce qu'**une connaissances a priori sur l'évolution spatio-temporelle de la distribution d'hétérogénéité de champ magnétique est utilisée pour déterminer la distribution d'hétérogénéité de champ magnétique au niveau du second point dans le temps (19, 20, 21, 27), en particulier dans lequel la connaissance a priori sur l'évolution spatio-temporelle de la distribution d'hétérogénéité de champ magnétique est déduite à partir d'une connaissance a priori sur l'évolution spatio-temporelle de l'unité fonctionnelle (17) et/ou d'une connaissance a priori sur l'évolution temporelle (18) de la caractéristique physiologique mesurée (14).

11. Procédé selon l'une quelconque des deux revendications précédentes, **caractérisé en ce que** la distribution d'hétérogénéité de champ magnétique au niveau du second point dans le temps (19, 20, 21, 27) est déterminée par un procédé d'extrapolation et/ou par interpolation entre deux distributions d'hétérogénéité de champ magnétique mesurées.

12. Procédé selon l'une quelconque des revendications précédentes, **caractérisé en ce que** le courant de compensation est déterminé pendant une acquisition de données de RM, en particulier le courant de compensation étant déterminé plusieurs fois pendant l'acquisition de données de RM ou le courant de compensation étant déterminé en temps réel.

13. Agencement de mesure de RM (1) comprenant un appareil de RM (2) présentant une bobine d'homogénéisation (3, 4) et comprenant un dispositif de mesure séparé (5, 6, 7) pour mesurer une caractéristique physiologique (14) d'un sujet (9), **caractérisé en ce que** le dispositif de mesure (5, 6, 7) est connecté à l'appareil de RM (2) et **en ce que** l'agencement de mesure de RM (1) est configuré pour mettre en oeuvre le procédé de l'une quelconque des revendications précédentes.

14. Agencement de mesure de RM (1) selon la revendication précédente, **caractérisé en ce que** la bobine d'homogénéisation (3, 4) fait partie d'un insert d'homogénéisation à bobines multiples (4).

15. Agencement de mesure de RM (1) selon l'une quelconque des deux revendications précédentes, **caractérisé en ce que** le dispositif (5, 6, 7) est un dispositif (6) qui est adapté pour mesurer un signal cardiaque (14) du sujet, tel qu'une impulsion du sujet, en particulier le dispositif (5, 6, 7) étant un déclencheur cardiaque de bout de doigt (6) qui peut être clipsé sur le doigt (8) du sujet (9), et/ou **en ce que** le dispositif (5, 6, 7) est un dispositif (7) pour mesurer un signal respiratoire (14) d'un sujet (9) tel qu'une ceinture respiratoire (7) qui peut de préférence être agencée autour du corps (10), en particulier autour du torse (10), du sujet (9).
